# EUROPÄISCHE PATENTSCHRIFT

(11) **EP 1 467 406 B1**
(45) Veröffentlichungstag und Bekanntmachung des Hinweises auf die Patenterteilung: **03.01.2007**
(21) Anmeldenummer: 04006021.2
(22) Anmeldetag: 13.03.2004
(51) Int. Cl.: H01L 25/07

(54) **Modular aufgebautes Leistungshalbleitermodul**
Modular power semiconductor module
Ensemble de modules de puissance

(30) Priorität: 10.04.2003 DE 10316356
(43) Veröffentlichungstag der Anmeldung: 13.10.2004
(73) Patentinhaber: SEMIKRON Elektronik GmbH & Co. KG, 90431 Nürnberg (DE)
(72) Erfinder: Manz, Yvonne, 91085 Weisenberg (DE); Wahi, Aseem, 90425 Nürnberg (DE); Gruber, Markus, 92348 Berg (DE)

(56) Entgegenhaltungen:
- EP-A- 0 828 341
- EP-A- 1 263 045
- US-A- 4 600 968
- US-A- 5 485 350
- US-A1- 2002 027 283
- US-A1- 2002 153 532
- PATENT ABSTRACTS OF JAPAN Bd. 2000, Nr. 09, 13. Oktober 2000 (2000-10-13) -& JP 2000 156575 A (DENSO CORP), 6. Juni 2000 (2000-06-06)
- PATENT ABSTRACTS OF JAPAN Bd. 2002, Nr. 10, 10. Oktober 2002 (2002-10-10) & JP 2002 184940 A (MITSUBISHI ELECTRIC CORP), 28. Juni 2002 (2002-06-28)

## Beschreibung

Die Erfindung beschreibt ein modular aufgebautes Leistungshalbleitermodul. Grundsätzlich bestehen derartige Leistungshalbleitermodule aus einem Gehäuse mit Grundplatte und mindestens einem darin angeordneten elektrisch isolierenden Substrat. Dieses besteht seinerseits aus einem Isolierstoffkörper mit einer Mehrzahl darauf befindlicher gegeneinander isolierter metallischer Verbindungsbahnen und auf diesen befindlichen und mit diesen Verbindungsbahnen schaltungsgerecht verbundenen Leistungshalbleiterbauelementen. Vorteilhafterweise weist das Substrat auf seiner Unterseite eine flächige metallische Schicht, vergleichbar den Verbindungsbahnen, auf.

Prinzipiell sind derartige Leistungshalbleitermodule, wie sie beispielhaft in der DE 39 37 045 A1 offengelegt sind, seit langem bekannt. Verschiedene moderne Ausgestaltungen derartiger Leistungshalbleitermodule mit hoher Leistung bezogen auf ihre Baugröße, die Ausgangspunkt dieser Erfindung sind, sind beispielhaft bekannt aus der DE 100 11 633 A1.

Die DE 39 37 045 A1 offenbart beispielhaft eine Leistungshalbleitermodul der oben genannten Art, welches innerhalb eines Gehäuses eines Halbbrückenschaltung aufweist. Eine derartige Schaltungsanordnung besteht aus zwei in Reihe geschalteten Leistungsschaltern, welche häufig als Serienschaltung von Leistungstransistoren, vorzugsweise Insulated Gate Bipolar Transistoren (IGBTs), ausgeführt ist. Antiparallel zu den jeweiligen Leistungsschaltern sind Freilaufdioden angeordnet. Das Leistungshalbleitermodul weist weiterhin Anschlusselemente für die Gleich- und Wechselstromlastanschlüsse auf. Zur Ansteuerung der Leistungstransistoren sowie für weitere Funktionen weisen derartige Leistungshalbleitermodule weiterhin Hilfsanschlusselemente auf.

Typische Leistungshalbleitermodule weisen eine Mehrzahl von Schraubverbindungen zur Montage auf flächigen Körpern, in der Regel externen Kühlkörpern auf. Die Löcher für derartige Schraubverbindungen sind vorzugsweise in den Eckbereichen der Leistungshalbleitermodule angeordnet.

Beispielhaft aus der DE 100 11 633 A1 ist ein weiteres Leistungshalbleitermodul bekannt, welches drei Halbbrückenschaltungen, also eine 3-Phasen Vollbrückenschaltung, innerhalb eines Gehäuses aufweist. Die Halbbrückenschaltungsanordnungen sind in drei Teilbereichen des Gehäuses angeordnet. Die jeweiligen Schaltungsanordnungen entsprechen hier ebenfalls dem oben beschriebenen Stand der Technik.

Nachteilig an der Ausgestaltung von Leistungshalbleitermodule mit einer Halbbrückenschaltung pro Gehäuse, vgl. DE 39 37 045 A1, ist, dass beim Aufbau von 3-Phasen Vollbrückenschaltungen aus diesen Einzelmodulen jedes Modul getrennt auf dem Kühlkörper befestigt werden muss. Somit ist auch ein Ersatz eines Leistungshalbleitermoduls, vgl. DE 100 11 633 A1, mit 3-Phasen Vollbrückenschaltung durch o.g. Einzelmodule nicht durch einfachen Tausch möglich, da die Befestigungsmöglichkeiten nicht identisch sind.

Andererseits erweist sich eine 3-Phasen Vollbrückenschaltung innerhalb eines Gehäuses als nachteilig, da hierbei während der Fertigung festgestellte Fehler innerhalb einer Halbbrückenschaltung einen Defekt des gesamten Moduls darstellen. Weiterhin ist es nachteilig, dass für andere Schaltungsanordnungen, beispielhaft eine H-Brücke, andere Gehäuse mit hier beispielhaft 2 Halbbrückenschaltungen notwendig sind und somit eine rationelle Fertigung mit einer geringen Anzahl von Baugruppen nicht möglich ist.

Aus der EP 0 828 341 A2 ist ein Leistungshalbleitermodul bekannt, das in einem Gehäuse eine Mehrzahl von Einzelsubstraten aufweist. Diese Leistungshalbleitermodule werden durch Verschienungen außerhalb der Module zu funktionellen Einheiten verbunden. Aus der EP 1 263 045 A1 sind Teilmodule eines Hochleistungshalbleitermoduls bekannt, die eigene Gehäuse aufweisen und mit Verschienungen zu einem Gesamtmodul verbunden werden.

Aus der US 2002/027283 A1 ist ebenso die Verbindung einzelner Teilmodule zu einem Gesamtmodul bekannt.

Die JP 20001156575 A offenbart eine Anordnung zur Aneinanderreihung von einer Mehrzahl von Leistungshalbleitermodulen. Hierzu werden Koppelelemente die in die Anschraublöcher der einzelnen Module eingesetzt und diese somit zueinander positioniert. Die Teilmodule werden beispielhaft mit einer Treiberplatine miteinander verbunden.

Der vorliegenden Erfindung liegt die Aufgabe zu Grunde ein Leistungshalbleitermodul vorzustellen, das einen modularen Aufbau aus einer Mehrzahl gleichartiger Teilmodule aufweist.

Diese Aufgabe wird gelöst durch ein Leistungshalbleitermodul nach dem Anspruch 1, spezielle Ausgestaltungen finden sich in den Unteransprüchen.

Der Grundgedanke der Erfindung geht aus von einem Leistungshalbleitermodul mit Grundplatte zur Montage auf einem flächigen Körper, vorzugsweise einem Kühlkörper, nach dem genannten Stand der Technik bestehend aus einem rahmenartigen Gehäuse mit mindestens einem darin angeordneten elektrisch isolierenden Substrat. Dieses Substrat besteht seinerseits aus einem Isolierstoffkörper mit einer Mehrzahl von auf seiner ersten Hauptfläche befindlichen gegeneinander isolierten metallischen Verbindungsbahnen sowie vorzugsweise aus einer auf seiner zweiten Hauptfläche angeordneten flächigen metallischen Schicht. Auf den Verbindungsbahnen der ersten Hauptfläche und mit diesen Verbindungsbahnen schaltungsgerecht verbunden sind eine Mehrzahl von Leistungshalbleiterbauelementen angeordnet.

Das erfindungsgemäße Leistungshalbleitermodul besteht aus einer Mehrzahl von Teilmodulen der oben genannten Art. Jedes Teilmodul weist Last- und Hilfsanschlusselemente auf, wobei die Lastanschlüsse vorzugsweise als je ein Plus-, ein Minus- und mindestens ein Wechselstromanschluss ausgebildet sind. Die Hilfsanschlüsse dienen der Ansteuerung der Leistungshalbleiterbauelemente sowie beispielhaft als Kontrollanschlüsse oder zur Kontaktierung von im Leistungshalbleitermodul angeordneten Sensorikbauteilen.

Erfindungsgemäß weist jedes Teilmodul mindestens zwei rund- oder langlochartige, nicht allseits umschlossene Ausnehmungen auf, die sich bei der Anordnung der Teilmodule zu einem Leistungshalbleitermodul an den jeweils aneinander angrenzenden Seiten zu Rund- oder Langlöchern ergänzen

Die Teilmodule werden vorteilhafteniveise durch fixierende Elemente zu einem Leistungshalbleitermodul verbunden. Als fixierendes Element sind beispielhaft ein alle Teilmodule übergreifender Deckel und / oder Verbindungen im Bereich der rahmenartigen Gehäuse und / oder im Bereich der Grundplatten geeignet.

Vorteilhaft an dieser Ausgestaltung eines Leistungshalbleitermoduls ist, dass
- durch die Aufteilung in Teilmodule diese im Fehlerfall einzeln getauscht werden können,
- durch gleichartige Teilmodule eine Fertigung verschiedener Leistungshalbleitermodule mit einem geringeren Teileaufwand durchführbar ist und
- trotz der Ausgestaltung aus einzelnen Teilmodulen das Leistungshalbleitermodul kompatibel zum Stand der Technik, beispielhaft einer 3-Phasen Vollbrückenschaltung, ist.
- Durch die geeignete Ausbildung der Ausnehmungen können zwei Teilmodule mittels jeweils einer "gemeinsamen" Schraube auf einem Kühlkörper fixiert werden.

Die Erfindung wird anhand von Ausführungsbeispielen in Verbindung mit den Fig. 1 bis 7 näher erläutert.
- Fig. 1: zeigt ein Teilmodul eines erfindungsgemäßen Leistungshalbleitermoduls in Draufsicht.
- Fig. 2: zeigt die Anordnung von drei Teilmodulen zu einem erfindungsgemäßen Leistungshalbleitermodul.
- Fig. 3: zeigt einen Teilausschnitt eines erfindungsgemäßen Leistungshalbleitermoduls in Draufsicht (a) sowie in seitlicher Ansicht (b).
- Fig. 4: zeigt eine weitere Ausgestaltung eines erfindungsgemäßen Leistungshalbleitermoduls mit einer Schnapp- Rastverbindung des Deckels.
- Fig. 5: zeigt in einem Ausschnitt eine weitere Ausgestaltung eines erfindungsgemäßen Leistungshalbleitermoduls mit Schnapp- Rastverbindung der Teilmodule.
- Fig. 6: zeigt ein erfindungsgemäßes Leistungshalbleitermodul mit einer Verbindung der Teilmodule gemäß Fig. 5
- Fig. 7.: Zeigt ein erfindungsgemäßes Leistungshalbleitermodul mit einem drei Teilmodule überlappenden Deckel.

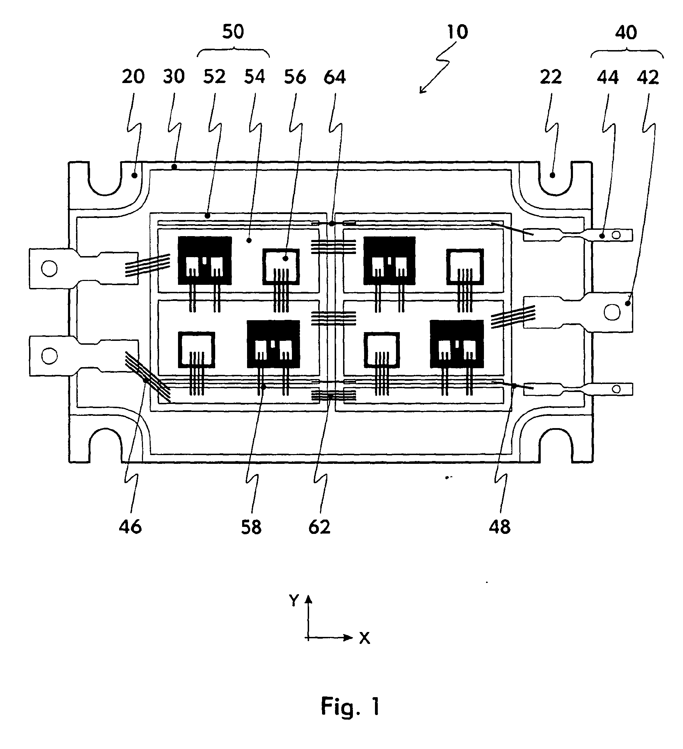

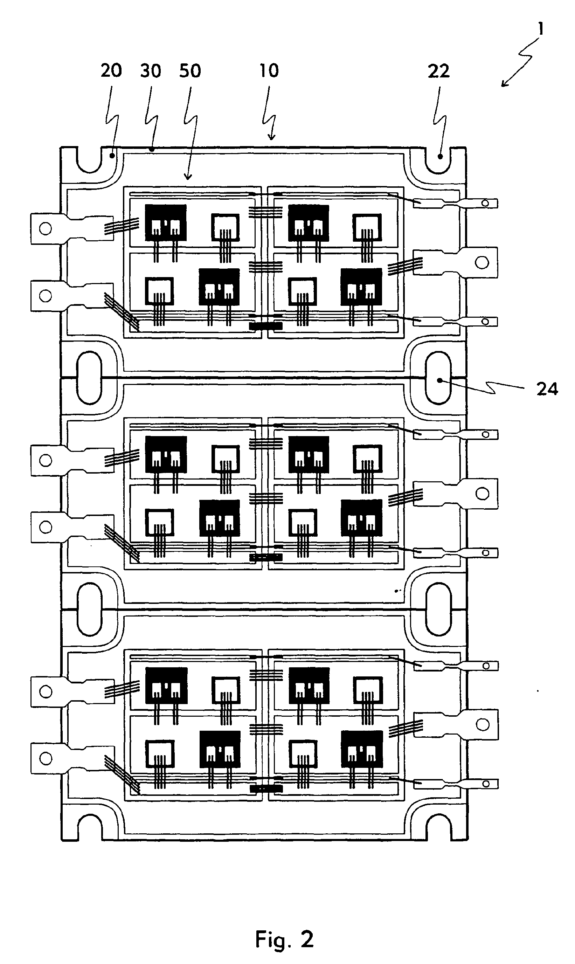

Fig. 1 zeigt ein Teilmodul eines erfindungsgemäßen Leistungshalbleitermoduls in Draufsicht. Dargestellt ist ein Teilmodul (10) bestehend aus einer Grundplatte (20) zur Montage auf einem Kühlkörper. Hierzu weist diese Grundplatte (20) im Bereich ihrer Ecken jeweils eine offene langlochartige Ausnehmung (22) auf. Diese sind derart im Randbereich angeordnet, dass deren Öffnungen auf denjenigen Seiten der Grundplatte angeordnet sind, die einem weiteren Teilmodul (10) des Leistungshalbleitermoduls zugeordnet sind (vgl. Fig. 2).

Das Teilmodul besteht weiterhin aus einem rahmenartigen Gehäuse (30) sowie zwei elektrisch isolierenden Substraten (50). Das jeweilige Substrat besteht seinerseits aus einem Isolierstoffkörper (52) mit einer Mehrzahl von auf seiner ersten der Grundplatte abgewandten Hauptfläche befindlichen gegeneinander isolierten metallischen Verbindungsbahnen (54). Auf seiner zweiten dem Kühlköper zugewandten Hauptfläche weist das Substrat eine den Verbindungsbahnen der ersten Hauptfläche gleichartige flächige Metallisierung auf. Auf den Verbindungsbahnen (54) und mit diesen schaltungsgerecht mittels Drahtbondverbindungen (58) verbunden sind Leistungshalbleiterbauelemente (56) angeordnet. Zur elektrische Kontaktierung weist das Teilmodul (10) Anschlusselemente (40) für die Last- (42) sowie die Hilfsanschlüsse (44) auf. Die Verbindungsbahnen (54) der Substrate (50) sind miteinander und mit den Anschlussementen (40) mittels Drahtbondverbindungen (62, 64, 46, 48) verbunden. Alternativ sind selbstverständlich auch Lötverbindungen möglich.

Fig. 2 zeigt in Draufsicht die Anordnung von drei Teilmodulen (10), gemäß Fig. 1, zu einem erfindungsgemäßen Leistungshalbleitermodul (1). Die Teilmodule (10) sind mit ihren Längsseiten zueinander angeordnet. Hierbei ergeben sich aus den offenen langlochartigen Ausnehmungen (22, Fig. 1) an den Kontaktstellen der Teilmodule (10) jeweils zur Hälfte von diesen Ausnehmungen gebildete Langlöcher (24). Diese Langlöcher dienen ebenso wie die an den Schmalseiten des Leistungshalbleitermoduls verbliebenen Ausnehmungen (22) der Befestigung des Leistungshalbleitermoduls (1) auf einem Kühlkörper.

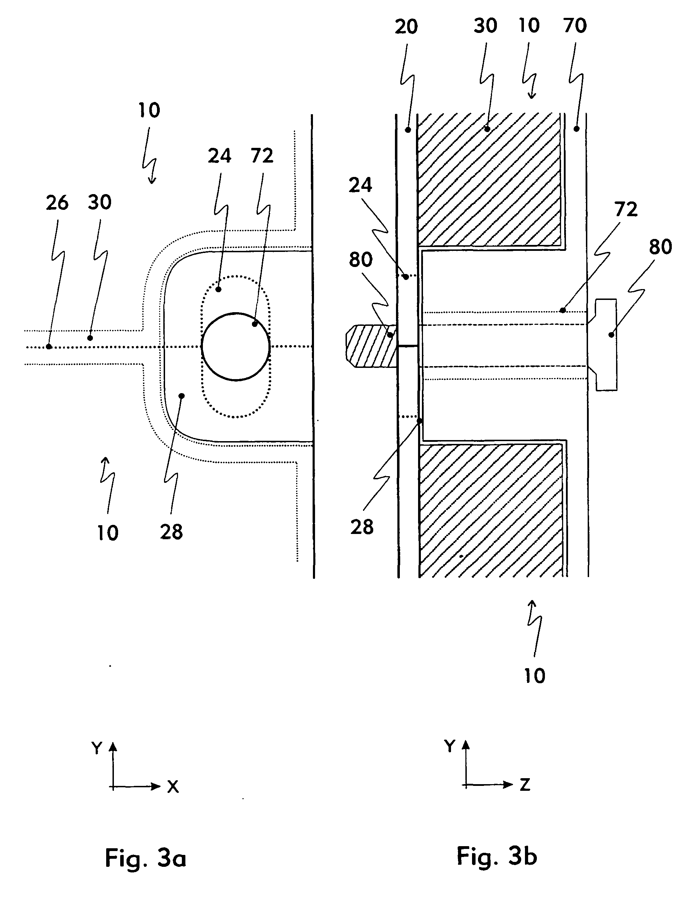

Fig. 3 zeigt einen Teilausschnitt eines erfindungsgemäßen Leistungshalbleitermoduls in Draufsicht (a) sowie in seitlicher Ansicht (b). Hierbei sind das Gehäuse (30) sowie eines der bereits in Fig. 2 beschrieben Langlöcher (24) dargestellt, welches sich an der Stoßkante (26) zweier Teilmodule (10) bildet. Weiterhin dargestellt ist ein Rundloch (72) des Deckels (70). Dieser Deckel (70) überschließt beide Teilmodule (10) und fixiert mittels einer Schraube (80) die beiden Teilmodule auf einem Kühlkörper. Der Deckel (70) weist hierzu eine Anschlagfläche auf, die auf dem durch das Gehäuse (30) ausgesparten Teilen (28) der Grundplatte (20) aufliegt.

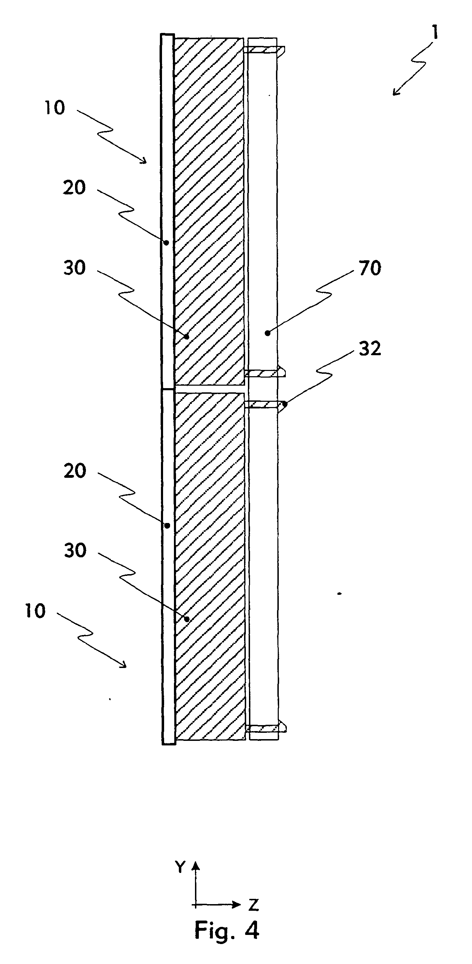

Fig. 4 zeigt eine weitere Ausgestaltung eines erfindungsgemäßen Leistungshalbleitermoduls mit einer Schnapp- Rastverbindung des Deckels. Jedes der auf einer Grundplatte (20) jedes Teilmoduls (10) angeordneten Gehäuses (30) weist eine Mehrzahl von Rastnasen (32) auf. Diese Rastnasen bilden mit den zugeordneten Widerlagern des Deckels (70) eine Schnapp-Rastverbindung. Hiermit entsteht durch Montage des Deckels (70) aus den einzelnen Teilmodulen (10) ein modular aufgebautes Leistungshalbleitermodul mit zueinander fixierten Teilmodulen.

Alternativ kann selbstverständlich der Deckel (70) die Rastnasen und das Gehäuse (30) die zugeordneten Widerlager aufweisen.

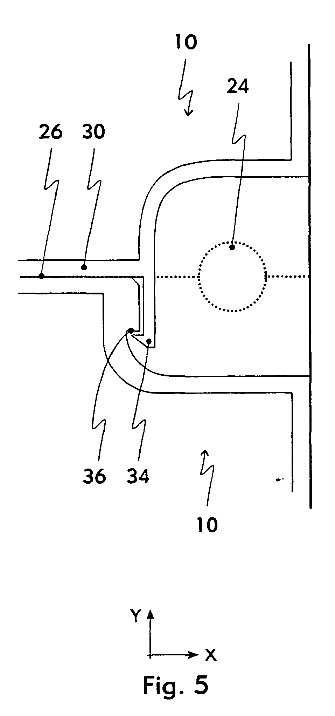

Fig. 5 zeigt in einem Ausschnitt eine weitere Ausgestaltung eines erfindungsgemäßen Leistungshalbleitermoduls mit Schnapp- Rastverbindung der Teilmodule (10). Es bieten sich verschiedene, auch miteinander kombinierbare Varianten der fixierenden Verbindung der Teilmodule zueinander an. Es können die Grundplatte, die Gehäuse und / oder die Deckel derartige fixierende Verbindungen aufweisen. Beispielhaft ist hier eine fixierende Schnapp-Rastverbindung der Gehäuse (30) gezeigt. Jedes Gehäuse weist an einer einem weiteren Teilmodul zugewandten Seite mindestens eine, vorzugsweise zwei, Rastnasen (34) auf. Die Rastnase (34) des einen Teilgehäuses (10) bildet mit dem Widerlager des weiteren Teilgehäuses (10) eine fixierende Verbindung. Somit entsteht aus einer Mehrzahl einzelner Teilmodule das gesamte Leistungshalbleitermodul. In dieser Ausgestaltung weisen die Grundplatten (20) der Teilmodule sich gegenüberstehende Halblöcher (22) auf. Dies bilden bei der Montage ein Rundloch (24) zur Befestigung des Leistungshalbleitermoduls auf einem Kühlkörper.

Eine Alternative zur Verbindung einzelner benachbarten Teilmodule (10) ist eine an den jeweiligen Längsseiten des Leistungshalbeitermoduls angeordnete, die durch das Gehäuse ausgesparten Flächen (28, Fig. 3) überdeckende, und hierzu Anschlagflächen aufweisende, vorzugsweise metallische, Schiene. Dieses, die Teilmodule zu einem Leistungshalbleitermodul fixierende Elemente, weist Rundlöcher für Schraubverbindungen mit dem Kühlkörper auf. Diese Rundlöcher sind in der Flucht vorzugsweise alle Ausnehmungen (22) sowie der daraus gebildeten Rund- oder Langlöcher (24) der jeweiligen Seite angeordnet.

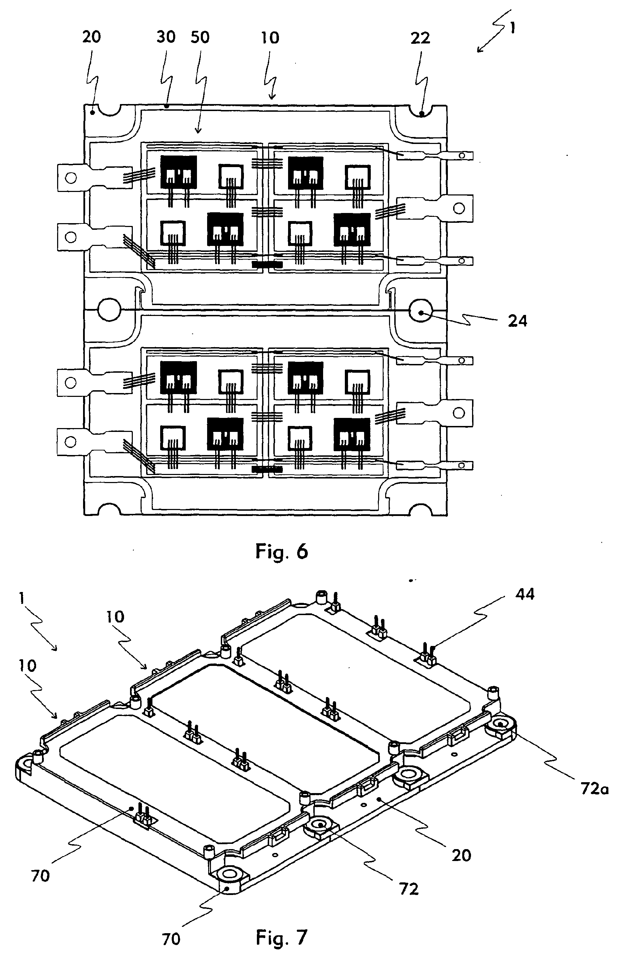

Fig. 6 zeigt in Draufsicht ein erfindungsgemäßes Leistungshalbleitermodul mit einer fixierenden Verbindung der beiden Teilmodule gemäß Fig. 5. Die beiden Rundlöcher (24) sowie die Halblöcher (22) dienen der Befestigung (vgl. Fig. 7) auf einem Kühlkörper. Dieses Leistungsmodul weist pro Teilmodul jeweils einen Deckel (nicht dargestellt) auf, da hier die fixierende Verbindung bereits durch die Schnapp- Rastverbindung der Gehäuse (30) gegeben ist.

Fig. 7 zeigt ein erfindungsgemäßes Leistungshalbleitermodul (1) mit einem die drei Teilmodule (10) überlappenden Deckel (70). Der Deckel (70) weist an seinen jeweiligen Ecken Fortsetzungen (74) auf, die die Grundplatte überragen und bis auf den Kühlkörper ausgedehnt sind, um eine sichere Schraubverbindung durch die Rundlöcher (72a) des Deckels (70) sowie die Halblöchern (22, vgl. Fig. 6) mit einem Kühlkörper zu gewährleisten. Die Hilfsanschlüsse (44) sind bei dieser Ausgestaltung des Leistungshalbleitermoduls (1) nicht an den Schmalseiten der Teilmodule (10) sondern entlang deren Längsseiten angeordnet.

## Patentansprüche

1. Leistungshalbleitermodul (1) zur Montage auf einem flächigen Körper bestehend aus einer Mehrzahl von Teilmodulen (10), welche ihrerseits aus einer Grundplatte (20) sowie einem rahmenartigen Gehäuse (30) und Anschlusselementen (40) für Last- (42) und Hilfsanschlüsse (44) bestehen, mit mindestens einem innerhalb jedes Gehäuses (30) auf der jeweiligen Grundplatte (20) angeordneten elektrisch isolierenden Substrat (50), das seinerseits besteht aus einem Isolierstoffkörper (52) mit einer Mehrzahl von darauf befindlichen gegeneinander isolierten metallischen Verbindungsbahnen (54), darauf befindlichen und mit diesen Verbindungsbahnen schaltungsgerecht verbundenen Leistungshalbleiterbauelementen (56), wobei das Leistungshalbleitermodul genau einen, die einzelnen Teilmodule verbindenden und gegeneinander fixierenden Deckel (70) aufweist und / oder alle Teilmodule mittels fixierenden Verbindungen (34,36) zueinander angeordnet sind,
**dadurch gekennzeichnet, dass**
jedes Teilmodul (10) mindestens zwei rund- oder langlochartige, nicht allseits umschlossene Ausnehmungen (22) aufweist, die sich bei der Anordnung der Teilmodule (10) zu einem Leistungshalbleitermodul (1) an den jeweils aneinander angrenzenden Seiten zu Rund- oder Langlöchern ergänzen.

2. Leistungshalbleitermodul nach Anspruch 1, wobei
der Deckel (70) mit den Teilmodulen (10) mittels Schnapp- Rastverbindungen verbunden ist, wobei die Gehäuse (30) Rastnasen (32) und der Deckel (70) diesen zugeordnete Widerlager aufweist.

3. Leistungshalbleitermodul nach Anspruch 1, wobei
der Deckel (70) rundlochartige Ausnehmungen (72) zur Aufnahme von Schrauben (80) aufweist, welche im Stoßbereich (26) der Teilmodule (10) in der Flucht mit den dort Rund- oder Langlöcher (24) bildenden Ausnehmungen (22) angeordnet sind.

4. Leistungshalbleitermodul nach Anspruch 1, wobei
jedes Teilmodul (10) an einer Grenzseite zu weiteren Teilmodulen mindestens eine Rastnase (34) sowie auf der gegenüberliegenden Grenzseite mindestens ein dieser Rastnase zugeordnetes Widerlager (36) aufweist.

5. Leistungshalbleitermodul nach Anspruch 5, wobei
die fixierende Verbindung als eine Schnapp- Rastverbindung (34, 36) aller direkt benachbarten Teilmodule ausgebildet ist.

6. Leistungshalbleitermodul nach Anspruch 1, wobei
die fixierende Verbindung als alle Ausnehmungen (22) sowie die daraus gebildeten Rund- oder Langlöcher (24) der jeweiligen Seite überdeckende Schiene ausgebildet ist.

## Claims

1. A power semiconductor module (1) for mounting on a flat body comprising a plurality of partial modules (10), which each in turn comprise a base plate (20) and a framelike housing (30) and terminal elements (40) for load- (42) and auxiliary- (44) terminals, with at least one electrically insulated substrate (50) arranged inside said housing (30) on the respective base plate (20), which in turn comprises an insulation material body (52) with a plurality of metal connection tracks (54) located thereon and insulated from one another, power semiconductor components (56) located thereon and with said connection tracks electrically connected according to a circuit, wherein
the power semiconductor module has exactly one cover (70) that connects and fixes to one another the individual partial modules and/or all the partical modules are arranged by means of fixing connections (34,36) relative to one another,
**characterised in that**,
each partial module (10) has at least two round- or oblong-type, not surrounded on all sides, recesses (22), which in the arrangement of the partial modules (10) to make a power semiconductor module (1) are completed at the sides respectively bordering each other as round- or oblong - holes.

2. The power semiconductor module of claim 1, wherein the cover (70) is connected with the partial modules (10) by means of snap-detent connections, wherein the housing (30) has detent lugs 32 and the cover (70) has abutments allocated to these.

3. The power semiconductor module of claim 1, wherein the cover (70) has round- hole-like recesses (72) for receiving screws (80), which in the abutting region (26) of the partial modules (10) are arranged in alignment with the there round- and oblong-holes (24) forming recesses (22).

4. The power semiconductor module of claim 1, wherein each partial module (10) has at a bordering side to further partial modules at least one detent lug (34) and on the opposite bordering side has at least one abutment 36 allocated to this detent lug.

5. The power semiconductor module of claim 5, wherein the fixing connection is constructed as a snap-detent connection (34,36) to directly neighbouring partial modules.

6. The power semiconductor module of claim 1, wherein the fixing connection is constructed as a rail that covers all recesses (22) and the therefrom formed round- or oblong-holes (24) of respective sides.

## Revendications

1. Module à semi-conducteurs de puissance (1) pour le montage sur un corps plat comprenant une pluralité de modules partiels (10), qui sont constitués pour leur part d'une plaque de base (20) et d'un boîtier (30) de type cadre et d'éléments de raccordement (40) pour des branchements de charge (42) et des branchements auxiliaires (44), avec au moins un substrat (50) électriquement isolant, disposé à l'intérieur de chaque boîtier (30) sur la plaque de base (20) respective, qui pour sa part est à base d'un corps en matériau isolant (52) avec une pluralité de bandes de liaison (54) métalliques, isolées les unes par rapport aux autres et se trouvant dessus, de composants à semi-conducteurs de puissance (56) se trouvant dessus et reliés conformément au montage à ces bandes de liaison, le module à semi-conducteurs de puissance présentant exactement un couvercle (70) reliant les modules partiels individuels et les fixant les uns par rapport aux autres et/ou tous les modules partiels étant disposés les uns par rapport aux autres au moyen d'assemblages (34, 36) de fixation,
**caractérisé en ce que**
chaque module partiel (10) présente au moins deux évidements (22) en forme de trou circulaire ou oblong, non fermés de tous les côtés, qui se complètent dans le cas de l'agencement des modules partiels (10) pour former un module à semi-conducteurs de puissance (1) sur les côtés respectivement contigus en des trous ronds et/ou des trous oblongs.

2. Module à semi-conducteurs de puissance selon la revendication 1,
le couvercle (70) étant relié aux modules partiels (10) au moyen d'assemblages à encliquetage, le boîtier (30) présentant des ergots d'encliquetage (32) et le couvercle (70) des butées attribuées à ces ergots.

3. Module à semi-conducteurs de puissance selon la revendication 1,
le couvercle (70) présentant des évidements (72) de type trou rond pour le logement de vis (80), qui sont disposées dans la zone de jointure (26) des modules partiels (10) en alignement avec les évidements (22) formant à cet endroit des trous circulaires ou oblongs (24).

4. Module à semi-conducteurs de puissance selon la revendication 1,
chaque module partiel (10) présentant sur un côté limite avec d'autres modules partiels au moins un ergot d'encliquetage (34) et sur le côté limite opposé au moins une butée (36) attribuée à cet ergot d'encliquetage.

5. Module à semi-conducteurs de puissance selon la revendication 5,
l'assemblage de fixation étant conçu comme un assemblage à encliquetage (34, 36) de tous les modules partiels directement voisins.

6. Module à semi-conducteurs de puissance selon la revendication 1,
l'assemblage de fixation étant conçu comme un rail recouvrant tous les évidements (22) ainsi que les trous ronds ou oblongs (24) formés à partir de ceux-ci, du côté concerné.
